(19) Europäisches Patentamt / European Patent Office / Office européen des brevets

(11) **EP 3 157 070 B1**

(12) **EUROPÄISCHE PATENTSCHRIFT**

(45) Veröffentlichungstag und Bekanntmachung des Hinweises auf die Patenterteilung:
**01.08.2018   Patentblatt 2018/31**

(51) Int Cl.:
**H01L 39/02** *(2006.01)*     **H01R 4/68** *(2006.01)*
**H01B 12/06** *(2006.01)*     **H01F 6/06** *(2006.01)*

(21) Anmeldenummer: **16193285.0**

(22) Anmeldetag: **11.10.2016**

(54) **SUPRALEITERSTRUKTUR ZUR VERBINDUNG VON BANDLEITERN, INSBESONDERE MIT EINER GEWELLT ODER GEZACKT VERLAUFENDEN NAHT**

SUPERCONDUCTOR STRUCTURE FOR CONNECTING BELT CONDUCTORS, IN PARTICULAR WITH A CORRUGATED OR SERRATED SEAM

STRUCTURE SUPRACONDUCTRICE DESTINÉE À RELIER DES RUBANS CONDUCTEURS, EN PARTICULIER À L'AIDE D'UNE SOUDURE ONDULÉE OU DENTELÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.10.2015   DE 102015219956**

(43) Veröffentlichungstag der Anmeldung:
**19.04.2017   Patentblatt 2017/16**

(73) Patentinhaber: **Bruker HTS GmbH
63450 Hanau (DE)**

(72) Erfinder:
• **Betz, Ulrich
  63755 Alzenau (DE)**
• **Usoskin, Alexander
  63456 Hanau (DE)**

(74) Vertreter: **Kohler Schmid Möbus Patentanwälte Partnerschaftsgesellschaft mbB
Gropiusplatz 10
70563 Stuttgart (DE)**

(56) Entgegenhaltungen:
EP-A1- 0 556 837         EP-A2- 0 501 394
DE-A1-102012 218 251     JP-A- 2014 154 320

EP 3 157 070 B1

**Beschreibung**

Die Erfindung betrifft Supraleiterstruktur, umfassend ein erstes Bandstück mit einer ersten Breite B1, ein zweites Bandstück mit einer zweiten Breite B2 und ein drittes Bandstück mit einer dritten Breite B3, wobei die Bandstücke jeweils ein Substrat und eine auf dem Substrat abgeschiedene, supraleitende Schicht aufweisen,

wobei ein Endabschnitt des zweiten Bandstücks und ein Endabschnitt des dritten Bandstücks über eine Schicht aus einem ersten normalleitenden Material mit dem ersten Bandstück verbunden sind, wobei das zweite und dritte Bandstück mit dem ersten Bandstück in Längsrichtung überlappen,

wobei die supraleitenden Schichten des zweiten und dritten Bandstücks der supraleitenden Schicht des ersten Bandstücks zugewandt sind,

wobei zwischen den Endabschnitten des zweiten und dritten Bandstücks eine Naht ausgebildet ist, wobei die Naht eine Pfadlänge PL aufweist mit PL > 2*B2 und PL > 2*B3,

insbesondere wobei sich die Schicht aus dem ersten normalleitenden Material auch unter der Naht erstreckt.

Eine solche Supraleiterstruktur ist aus der DE 10 2012 218 251 A1 bekannt geworden.

Supraleiter werden dazu eingesetzt, elektrische Ströme verlustfrei zu tragen. Eine wichtige Anwendung sind insbesondere Magnetspulen zur Erzeugung großer Magnetfeldstärken, beispielsweise für NMR-Spektrometer und MRI-Systeme (NMR: nuclear magnetic resonance, Kernspinresonanz; MRI: magnetic resonance imaging, Bildgebende Magnetresonanz).

Supraleiter müssen bei einer kryogenen Temperatur unterhalb ihrer sogenannten Sprungtemperatur betrieben werden, da oberhalb dieser Temperatur der Supraleiter nur normalleitendes Verhalten zeigt. Hochtemperatur-Supraleiter (HTS) wie YBCO (yttrium barium copper oxide, Ytrium-Barium-Kupferoxid) weisen besonders hohe Sprungtemperaturen auf und können auch vergleichsweise große elektrische Ströme tragen. Allerdings sind HTS-Materialien in der Regel keramisch, so dass diese aus mechanischen Gründen meist in Gestalt von Bandleitern, also mit HTS-Material beschichteten bandförmigen Substraten, genutzt werden müssen. HTS-Bandleiter können nur mit begrenzten Längen hergestellt werden, so dass sich für wichtige Anwendungen wie Spulen die Notwenigkeit ergibt, Bandstücke von HTS-Bandleiter miteinander zu verbinden.

Aus der DE 10 2012 218 251 A1 ist eine Supraleiterstruktur mit verketteten Bandstücken bekannt, bei der die Bandstücke mit einander zugewandten supraleitenden Schichten überlappend angeordnet sind. Zwischen den supraleitenden Schichten ist normalleitendes Material angeordnet, was jedoch bei großen Überlappungslängen keinen merklichen ohmschen Widerstand einbringt. Der Spalt an zwei aneinander anstoßenden Bandstücken verläuft in der Regel senkrecht zur Erstreckungsrichtung. In einer Ausführungsform ist es jedoch vorgesehen, den Spalt an zwei aneinander stoßenden Bandstücken, die mit dem selben weiteren Bandstück überlappen, unter einem Wickel von 5-30° zur Erstreckungsrichtung der Bandstücke auszubilden. Dadurch sollen Inhomogenitäten des kritischen Stroms in Spaltnähe gut überbrückt werden können. Der Spalt verläuft im Wesentlichen gerade.

Aus der US 8,195,260 B2 ist es bekannt, bei einem HTS-Joint zwei Supraleiterdrähte mit keilförmigen Kanten aneinander anzustückeln und mit supraleitenden Spangen zu übergreifen.

Durch den Spalt bzw. die Anstückelstelle der Bandstücke wird nach der Beobachtung der Erfinder die Stromtragfähigkeit der jeweiligen Supraleiterstruktur insgesamt deutlich begrenzt. Auch entsteht am Spalt bzw. einer Anstückelstelle meist eine merkliche Verlustleistung. JP 2014154320 A offenbart eine Verzahnung supraleitender Bänder, ohne diese durch ein weiteres supraleitendes Band zu unterstützen.

Aufgabe der Erfindung

Der Erfindung liegt die Aufgabe ist es, in einer Supraleiterstruktur mit aneinander gestückelten Bandstücken eine höhere Stromtragfähigkeit zu erreichen. Bevorzugt soll auch eine Verlustleistung an den Anstückelstellen reduziert werden, und die Fertigung der Supraleiterstruktur soll bevorzugt insgesamt einfach und kostengünstig sein.

Kurze Beschreibung der Erfindung

Diese Aufgabe wird gelöst durch eine Supraleiterstruktur der eingangs genannten Art, die dadurch gekennzeichnet ist,

dass sich die Naht in Längsrichtung über einen Erstreckungsbereich der Supraleiterstruktur erstreckt, der eine Länge LBN aufweist, mit $0{,}5*PL \geq LBN$, bevorzugt $0{,}25*PL \geq LBN$.

Im Rahmen der vorliegenden Erfindung wird der der Stoß bzw. die Naht von zwei aneinander gestückelten Bandstücken so ausgeführt, dass die Pfadlänge PL der Naht (das ist die Länge der Strecke, die sich ergibt, wenn man entlang der Naht von einem Ende bis zum anderen Ende voranschreitet) wenigstens doppelt so groß ist, bevorzugt wenigstens viermal so groß ist, wie die Länge LBN in Längsrichtung (und Hauptstromflussrichtung) desjenigen Bereichs, über den sich die Naht in der Supraleiterstruktur erstreckt. Gleichzeitig ist die Pfadlänge PL wenigstens doppelt so groß wie die Breiten B2, B3 gewählt. Die erfindungsgemäße Supraleiterstruktur nutzt also eine Naht mit einer vergleichsweise großen Pfadlänge.

Ein entsprechender Stoß mit großer Pfadlänge kann im Rahmen der erfindungsgemäßen Geometrie im supraleitenden Zustand der Bandleiter ohmsche Verluste am Spalt reduzieren, insbesondere verglichen mit einem Spalt gleicher Weite (senkrecht zur Verlaufsrichtung des Spalts) und kürzerer Pfadlänge. Entsprechend der großen Pfadlänge PF gibt es einen großen Volumenbereich von nahe an der Naht liegendem Supraleitermaterial im zweiten und dritten Bandstück, und auch im ersten Bandstück.

In der Regel gilt weiterhin LBN ≥ B2, bevorzugt LBN ≥ 2*B2, und auch LBN ≥ B3, bevorzugt LBN ≥ 2*B3, so dass auch dadurch mit der Erfindung ein großer Volumenbereich von nahe an der Naht liegendem Supraleitermaterial erschlossen werden kann.

Die im Rahmen der vorliegenden Erfindung vorgesehenen Dimensionierungen können mit einem gegenüber der Längsrichtung schrägen, aber insgesamt im Wesentlichen geraden Verlauf einer Naht, wie ihn der Stand der Technik vorsieht, nicht erreicht werden. Insbesondere platziert die erfindungsgemäße Geometrie die Pfadlänge PF auf einer vergleichsweise kurzen Länge LBN. Im Rahmen der Erfindung weist die Naht entsprechend dafür auch meist einen zumindest abschnittsweise gewellten und/oder gezackten Verlauf auf. Durch die kompakte Ausführung ist die supraleitende Struktur relativ einfach und kostengünstig zu fertigen. Weiterhin vermeidet der kompakte Aufbau bzw. eine vergleichsweise kurze Länge LBN Konnektivitätsverluste (connectivity losses) im zweiten und dritten Bandleiter im Bereich der Naht.

Mit der erfindungsgemäßen Geometrie der Supraleiterstruktur hat sich experimentell eine verringerte Joule'sche Wärmeentwicklung an den Stößen von Bandstücken (also an den gegenüberliegenden Enden von zweitem und drittem Bandstück) von HTS-Bandleitern gezeigt, insbesondere gegenüber herkömmlichen geraden Stößen senkrecht zur Längsrichtung, aber auch gegenüber geraden Stößen schräg zur Längsrichtung. Dies gilt insbesondere, wenn der in der Supraleiterstruktur transportierte gesamte Arbeitsstrom IA größer ist als Ic1, aber kleiner ist als Ic1+Ic2 und auch kleiner ist als Ic1+Ic3, mit Ic1, Ic2, Ic3: kritische Stromstärke von erstem, zweitem und drittem Bandstück. Damit einher geht eine höhere kritische Stromstärke Ic der Supraleiterstruktur insgesamt. Im Rahmen der Erfindung kann Ic auf einfache Weise bis nahe an Ic1 + Ic2 und nahe an Ic1 + Ic3 herangeführt werden.

Die Erfinder vermuten, dass zwei Effekte zu den erfindungsgemäßen Verbesserungen beitragen:
Durch die erfindungsgemäße Geometrie wird zum einen eine erhebliche Brechung (oder Ablenkung gegenüber der Hauptstromflussrichtung) von Stromflusslinien im Bereich der Naht vom zweiten zum dritten Bandstück erzeugt, wobei die Stromflussrichtungen vom zweiten zum dritten Bandstück sich teilweise lokal erheblich unterscheiden können (sowohl untereinander entlang der Naht, als auch an der Naht im Vergleich zu Regionen entfernt von der Naht). Erfindungsgemäß können insbesondere entlang der Naht lokal einander teilweise oder vollständig entgegengesetzte Stromflussrichtungen vom zweiten zum dritten Bandstück durch das erste Bandstück hindurch auftreten. Dadurch kann möglicherweise im Supraleitermaterial der Bandstücke die effektive Stromstärke verringert werden. Weiterhin können insbesondere Nahtverläufe gewählt werden, bei denen sich das zweite und dritte Bandstück teilweise hintergreifen. Ein lokaler Stromfluss im Hintergriffbereich vom zweiten zum dritten Bandstück, der durch das erste Bandstück hindurch erfolgt, ist dann zumindest teilweise vektoriell der Hauptstromflussrichtung entgegengesetzt, und reduziert somit lokal die effektive Stromstärke im ersten Bandstück. Auch ohne einen Hintergriff kann bereits eine erhebliche Abweichung der Richtung des lokalen Stromflusses vom zweiten zum dritten Bandstück, der durch das erste Bandstück erfolgt, von der Hauptstromflussrichtung dazu beitragen, die effektive Stromstärke im ersten Bandstück weniger stark zu erhöhen als bei einer parallelen Ausrichtung. All dies kann zu einer höheren Stromtragfähigkeit der Supraleiterstruktur beitragen.

Zum anderen wird im Rahmen der Erfindung über eine vergrößerte genutzte Fläche eine Stromaufteilung zwischen erstem Bandstück einerseits und zweitem/dritten Bandstück andererseits erhalten. Der Strom verteilt sich besser zwischen den beiden Ebenen (einerseits erstes Bandstück und andererseits zweites/drittes Bandstück) der Supraleiterstruktur, so dass beide Ebenen einen erhöhten Beitrag zur Gesamtstromtragfähigkeit leisten können.

Die Endabschnitte des zweiten und dritten Bandstücks überlappen typischerweise zusammen im Wesentlichen (bis auf die Naht) die gesamte Länge des ersten Bandstücks. Typischerweise sind die Breiten B1, B2 und B3 gleich, und typischerweise sind die Bandstücken vom selben Typus von Bandleiter. Die supraleitenden Schichten der Bandstücke sind typischerweise aus HTS-material, insbesondere YBCO.

Man beachte, dass zwischen Substrat und supraleitender Schicht ein oder mehrere weitere Schichten, etwa Pufferschichten, angeordnet sein können. Die Schicht aus dem ersten normalleitenden Material kann durch weitere normalleitende Schichten ergänzt werden, so dass ein Multilayer-System eingerichtet wird.

Bevorzugte Ausführungsformen der Erfindung

Bei einer bevorzugten Ausführungsform der erfindungsgemäßen Supraleiterstruktur ist vorgesehen, dass die Naht den Erstreckungsbereich oder einen Teilbereich des Erstreckungsbereichs, der ein Teilstück des Erstreckungsbereichs in Längsrichtung herausgreift, bezüglich der Längsrichtung mehrfach durchläuft. Mit anderen Worten, die Naht verläuft im Erstreckungsbereich oder in dem Teilbereich des Erstreckungsbereichs bezüglich der Längsrichtung mindestens einmal hin und mindestens einmal zurück. Dadurch kann auf kompakten Raum, insbesondere über geringe Längen LBN, eine besonders große Pfadlänge der Naht untergebracht werden.

Ebenfalls bevorzugt ist eine Ausführungsform, bei der die Naht wenigstens zur Hälfte einen nichtlinearen und/oder polygonalen Verlauf hat. Dadurch können ebenfalls große Pfadlängen PL auf geringen Längen LBN untergebracht werden.

Besonders bevorzugt ist eine Ausführungsform, bei der die Naht wenigstens einen Teilabschnitt aufweist, in welchem sich eine Verlaufsrichtung der Naht um 180° oder mehr, insbesondere um 270° oder mehr, ändert. Dies ermöglicht zum einen wiederum die Unterbringung von großen Pfadlängen auf geringem Raum. Zum anderen bewirkt dies aber auch, dass die lokalen Stromflussrichtungen von zweitem zu drittem Bandleiter zumindest teilweise einander entgegengerichtet sind, wodurch eine Verringerung der effektiven Stromstärke in den Bandleitern erreicht werden kann. Dadurch kann eine erhöhte Stromtragfähigkeit der Supraleiterstruktur insgesamt erreicht werden. Bevorzugt weist die Naht eine Vielzahl, etwa 10 oder mehr, besagte Teilabschnitte mit 180° (oder mehr) Änderung der Verlaufsrichtung auf.

Bei einer bevorzugten Ausführungsform ist vorgesehen, dass die Naht in wenigstens einem Teilabschnitt gezackt oder gewellt verläuft, insbesondere wobei die Naht in dem Teilabschnitt in Form eines Keils mit einem beidseitig gezackten oder gewellten Rand verläuft. Durch einen gewellten oder gezackten Verlauf kann wiederum eine besonders große Pfadlänge auf kompaktem Raum, insbesondere bei kurzer Länge LBN, auf einfache Weise eingerichtet werden.

Vorteilhaft ist auch eine Ausführungsform, bei der die Naht wenigstens einen Teilabschnitt aufweist, in welchem die Naht schneckenförmig verläuft. Dies ermöglicht zum einen wiederum die Unterbringung von großen Pfadlängen auf geringem Raum. Zum anderen bewirkt dies aber auch, dass die lokalen Stromflussrichtungen von zweitem zu drittem Bandleiter zumindest teilweise einander entgegengerichtet sind, und auch teilweise der Hauptstromflussrichtung im ersten Bandleiter entgegengerichtet sind. Dadurch kann eine Verringerung der effektiven Stromstärke in den Bandstücken, insbesondere im ersten Bandstück, erreicht werden. Entsprechend wird eine erhöhte Stromtragfähigkeit der Supraleiterstruktur insgesamt ermöglicht.

Bevorzugt ist weiterhin eine Ausführungsform, die vorsieht, dass die Naht mehrere im Wesentlichen gleiche Teilstrukturen, insbesondere Zacken oder Wellen, ausbildet, die eine maximale Größe MG aufweisen, und dass die Supraleiterstruktur eine Stromabfall-Distanz SAD aufweist, mit MG < SAD, wobei SAD wie folgt bestimmt ist:

$$SAD = \sqrt{R_S t / \rho_0}$$

mit $R_S$: spezifischer Kontaktwiderstand einer Shunt-Schicht und der supraleitenden Schicht des ersten Bandstücks in Ohm*m²; t: Dicke oder effektive Dicke der Shunt-Schicht in m; $\rho_0$ spezifischer Widerstand oder effektiver spezifischer Widerstand der Shunt-Schicht in Ohm*m; wobei die Shunt-Schicht zumindest die Schicht aus dem ersten normalleitenden Material umfasst. Wenn die Shunt-Schicht eine metallische Multilayer-Schicht ist, treten die effektive Dicke bzw. der effektive spezifische Widerstand an die Stelle der Dicke bzw. des spezifischen Widerstands einer einfachen metallischen Shunt-Schicht. Bei dieser Ausführungsform können Stromflüsse, die von verschiedenen (benachbarten) Teilstrukturen ausgehen, noch zusammenwirken, insbesondere sich teilweise gegenseitig aufheben, wenn sie die Shunt-Schicht durchdrungen haben. Dadurch wird indirekt ein besonders niedriger ohmscher Widerstandsbeitrag der Shunt-Schicht erreicht. Die maximale Größe MG wird als lineare Dimension in der Ebene der supraleitenden Schicht von zweitem oder drittem Bandstück bestimmt.

Bei einer vorteilhaften Ausführungsform ist die Naht mit abgerundeten Ecken ausgebildet, so dass für einen kleinsten Krümmungsradius KKR der Naht gilt KKR ≥ 0,01*B2 und KKR ≥ 0,01*B3, bevorzugt wobei 0,2*B2 ≥ KKR ≥ 0,01*B2 und 0,2*B3 ≥ KKR ≥ 0,01*B3. Durch abgerundete Ecken oder allgemeiner einen ausreichend großen Krümmungsradius überall an der Naht werden lokale Stromspitzen vermieden, wodurch eine höhere Stromtragfähigkeit der Supraleiterstruktur insgesamt erreicht wird.

Vorteilhaft ist weiterhin eine Ausführungsform, die vorsieht, dass PL ≥ 5*B2 und PL ≥ 5*B3, bevorzugt PL ≥ 12*B2 und PL ≥ 12*B3, besonders bevorzugt PL ≥ 25*B2 und PL ≥ 25*B3. Durch die große Pfadlänge PF gibt es einen großen Volumenbereich von nahe an der Naht liegendem Supraleitermaterial im zweiten und dritten Bandstück, und auch im ersten Bandstück. Dieser Volumenbereich kann für den Stromübergang zwischen den Ebenen genutzt werden, so dass beide Ebenen einen hohen Beitrag zur Stromtragfähigkeit insgesamt leisten können. Typischerweise ist weiterhin 1000*B2 ≥ PL und 1000*B3 ≥ PL.

Eine bevorzugte Ausführungsform sieht vor, dass das zweite Bandstück eine Dicke D2 und das dritte Bandstück eine Dicke D3 aufweist, und die Naht eine Weite WT aufweist, mit 0,01*D2 ≤ WT ≤ 3*D2 und 0,01*D3 ≤ WT ≤ 3*D3, bevorzugt 0,02*D2 ≤ WT ≤ 2*D2 und 0,02*D3 ≤ WT ≤ 2*D3.
Die Weite ist der kleinste Abstand von einem Punkt am Rand der Naht zum gegenüberliegenden Rand der Naht. Gemäß dieser Variante ist die Weite ungefähr so groß wie die Dicken D2, D3 oder auch etwas kleiner. Bei diesen Dimensionen hat sich in der Praxis ein guter Stromtransfer ohne Überlastung des ersten Bandstücks eingestellt.

Bevorzugt ist auch eine Ausführungsform, bei der 2*B1 ≤ LBN ≤ 100*B1. Bei einer Länge LBN von wenigstens 2*B1 steht bereits genügend Raum für eine erhebliche Verlängerung der Pfadlänge zur Verfügung, ohne dass zu viele hintereinander liegende Hintergriffe eingerichtet werden müssten. Eine größere Länge LBN als 100*B1 bringt meist keine merkliche Verbesserung der Stromtragfähigkeit mehr.

Eine vorteilhafte Ausführungsform sieht vor, dass die Naht bezüglich einer Symmetrieebene, die entlang der Längsrichtung mittig durch die Supraleiterstruktur und senkrecht zu den Substraten verläuft, symmetrisch ausgebildet ist. Dadurch ist eine besonders gleichmäßige Verteilung der Ströme in den beiden Ebenen der Supraleiterstruktur möglich, wobei sich quer zur Hauptstromflussrichtung liegende, einander entgegengesetzte Stromanteile gegenseitig kompensieren können und so die Strombelastung der Bandstücke reduzieren können.

Vorteilhaft ist auch eine Ausführungsform, bei der die Naht zumindest teilweise mit einem zweiten normalleitenden Material ausgefüllt ist. Durch die Befüllung der Naht kann der ohmsche Widerstand der Naht reduziert werden, wodurch der Nahtbereich im Quenchfall besser vor einer Überhitzung geschützt ist. Zudem dann ein gewisser Beitrag zur Stromtragfähigkeit geleistet werden, insbesondere wenn die Naht eine geringe Weite (etwa kleiner als 10 μm) und/oder eine große Pfadlänge (etwa größer als 10*B1) aufweist. Das erste normalleitende Material und das zweite normalleitende Material können gleich gewählt werden. Das zweite normalleitende Material kann die Naht insbesondere vollständig ausfüllen.

Bevorzugt ist eine Weiterbildung dieser Ausführungsform, bei der das zweite normalleitende Material ein niederschmelzendes Lot mit einer Schmelztemperatur von 80°-350°C ist, insbesondere wobei das zweite normalleitende Material eine Legierung enthaltend Bi, Sn, Pb, Cd und/oder Sn mit Ausscheidungen von Ag, Au und/oder Cu ist. Diese Materialien sind leicht zu verarbeiten; durch die Ausscheidungen wird ein geringer spezifischer Widerstand sichergestellt.

Bei einer bevorzugten Ausführungsform weist die Naht wenigstens einen, bevorzugt wenigstens zwei, Teilabschnitte auf, an denen sich das zweite Bandstück und das dritte Bandstück gegenseitig hintergreifen. Ein Stromfluss vom zweiten Bandstück in das dritte Bandstück durch das erste Bandstück ist hier vektoriell zumindest teilweise dem Grundstrom im ersten Bandstück in Hauptstromrichtung entgegengesetzt, wodurch die Strombelastung im ersten Bandstück reduziert wird. Dadurch ist eine größere Stromtragfähigkeit (ohne Quench) der Supraleiterstruktur erreichbar.

Vorteilhaft ist weiterhin eine Ausführungsform, bei der das Material der supraleitenden Schichten der Bandstücke eine Anisotropie der jeweiligen kritischen Ströme in der jeweiligen Schicht entlang der Längsrichtung zu senkrecht zur Längsrichtung von 1,5 oder weniger, bevorzugt von 1,1 oder weniger, aufweist. Gemäß dieser Ausführungsform weisen die supraleitenden Schichten nur eine geringe oder auch gar keine Anisotropie auf. Dadurch wird sichergestellt, dass nicht-parallel zur Hauptstromflussrichtung fließende (also durch den Nahtverlauf "umgelenkte") Ströme im Rahmen eines Stromtransfers zwischen dem zweiten Bandstück und dem ersten Bandstück bzw. zwischen dem ersten Bandstück und dem dritten Bandstück die Stromtragfähigkeit problemlos im Supraleitermaterial transportiert werden können. Dadurch wird eine besonders hohe Stromtragfähigkeit der Supraleiterstruktur insgesamt erreichbar.

In den Rahmen der vorliegenden Erfindung fällt auch eine Supraleiterbaugruppe, umfassend mehrere erfindungsgemäße, oben beschriebene Supraleiterstrukturen, insbesondere wobei jeweils zwei Supraleiterstrukturen elektrisch seriell über ihr jeweiliges zweites oder drittes Bandstück miteinander verbunden sind. Im Rahmen der Erfindung können praktisch beliebig lange Supraleiterbaugruppen eingerichtet werden, mit denen elektrischer Strom verlustfrei transportiert werden kann. Insbesondere können Magnetspulen für sehr große Stromstärken, insbesondere 10 Tesla oder mehr, gewickelt werden. Die serielle Verbindung ist bevorzugt entsprechend der Verbindung zwischen einem ersten Bandstück und einem zweiten/dritten Bandstück einer Supraleiterstruktur ausgebildet.

Ebenfalls in den Rahmen der vorliegenden Erfindung fällt die Verwendung einer erfindungsgemäßen, oben beschriebenen Supraleiterstruktur und/oder einer erfindungsgemäßen, oben beschriebenen Supraleiterbaugruppe,

wobei das erste Bandstück eine kritische Stromstärke Ic1, das zweite Bandstück eine kritische Stromstärke Ic2, und das dritte Bandstück eine kritische Stromstärke Ic3 aufweist,

und wobei die Supraleiterstruktur mit einem Arbeitsstrom IA beaufschlagt wird, wobei gilt

Ic1 < IA < Ic1+Ic2 und Ic1 < IA < Ic1+Ic3,

bevorzugt 1,1*Ic1 ≤ IA ≤ 0,9*(Ic1+Ic2) und 1,1*Ic1 ≤ IA ≤ 0,9*(Ic1+ Ic3). Bei diesen Stromstärken ist die geringe Verlustleistung der Supraleiterstruktur besonders ausgeprägt, im Vergleich zu herkömmlichen HTS-HTS-Joints.

Eine bevorzugte Variante der erfindungsgemäßen Verwendung sieht vor, dass die Supraleiterstruktur und/oder Supraleiterbaugruppe verbaut ist in

- einer Magnetspule,
- einem Elektromotor oder einem Generator,
- einem Transformator, oder
- einer Stromleitung. Bei diesen Anwendung ist die hohe Stromtragfähigkeit besonders nützlich.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1:    eine erste Ausführungsform einer erfindungsgemäßen Supraleiterstruktur, in schematischer Schrägansicht, mit einer schneckenförmigen Naht;

Fig. 2:    eine schematische Aufsicht einer zweiten Ausführungsform einer erfindungsgemäßen Supraleiterstruktur, mit gezackter Naht;

Fig. 3:    eine schematische Aufsicht einer dritten Ausführungsform einer erfindungsgemäßen Supraleiterstruktur, mit gewellter Naht;

Fig. 4:    eine schematische Aufsicht einer vierten Ausführungsform einer erfindungsgemäßen Supraleiterstruktur, mit einer spiegelsymmetrischen, Hintergriffe ausbildenden Naht;

Fig. 5:    eine schematische Aufsicht einer fünften Ausführungsform einer erfindungsgemäßen Supraleiterstruktur, mit einer mehrere Schlaufen ausbildenden Naht;

Fig. 6    ein schematischer Längsschnitt einer Ausführungsform erfindungsgemäßen Supraleiterstruktur, mit durchgehender Schicht aus einem ersten normalleitenden Material, wobei die Naht teilweise mit einem zweiten metallischen Material befüllt ist;

Fig. 7    ein schematischer Längsschnitt einer Ausführungsform einer erfindungsgemäßen Supraleiterstruktur, mit durchgehender Schicht aus einem ersten normalleitenden Material, mit unbefüllter Naht;

Fig. 8    ein schematischer Längsschnitt einer Ausführungsform einer erfindungsgemäßen Supraleiterstruktur, mit an der Naht unterbrochener Schicht aus einem ersten normalleitenden Material;

Fig. 9    eine schematische Aufsicht auf eine Ausführungsform einer erfindungsgemäße Supraleiterstruktur, mit Stromflusslinien im Bereich der Naht;

Fig. 10    ein schematischer Längsschnitt einer Ausführungsform einer erfindungsgemäßen Supraleiterbaugruppe.

Die vorliegende Erfindung betrifft die Verbindung von Bandleitern mit einer supraleitenden Beschichtung, insbesondere HTS-Beschichtung. Die Bandstücke werden dabei mit einander zugewandten Supraleiterschichten mit gegenseitiger Überlappung aufeinander angeordnet, so dass über lange Strecken, insbesondere 10 m oder mehr, jeweils vor und hinter einem Stoß eine Überlappung besteht. An einem Stoß überbrückt ein erstes Bandstück in einer ersten Ebene die Enden von zwei Bandstücken (zweites und drittes Bandstück) in einer zweiten Ebene. Zwischen den Bandstücken der verschiedenen Ebenen ist eine normalleitende Schicht angeordnet, deren ohmscher Widerstand aufgrund einer langen Überlappung vernachlässigt werden kann. Zweites und drittes Bandstück bilden in der zweiten Ebene eine Naht (einen Stoß) aus. Im Rahmen der Erfindung wird die Naht so ausgebildet, dass zusammenfassend eine verbesserte, insbesondere näherungsweise galvanische Transparenz des Anstückelbereichs von zweitem und drittem Bandstück erhalten wird. Dies wird im Wesentlichen durch eine große Pfadlänge der Naht und einen geeigneten Verlauf der Naht mit zahlreichen Richtungsänderungen, insbesondere mit gezackter und/oder gewellter Naht oder auch mit Nahtabschnitten, an denen sich die zweites und drittes Bandstück gegenseitig hintergreifen, erreicht.

Typischerweise sind wenigstens 4, bevorzugt wenigstens 8, besonders bevorzugt wenigstens 12, Richtungsänderungen des Nahtverlaufs um wenigstens 60°, bevorzugt um wenigstens 90°, vorgesehen. Weiterhin weist die Naht typischerweise wenigstens 1, bevorzugt wenigstens 2, besonders bevorzugt wenigstens 4, hintergreifende Nahtabschnitte auf.

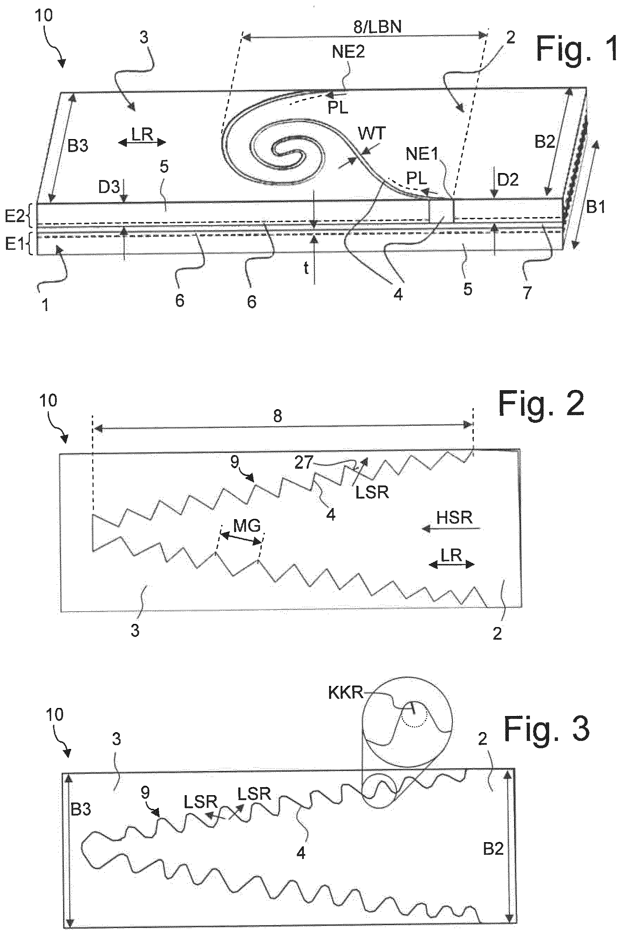

Die **Fig. 1** zeigt eine erste Ausführungsform einer erfindungsgemäßen Supraleiterstruktur 10. Die Supraleiterstruktur 10 umfasst ein erstes Bandstück 1 in einer ersten, hier unteren Ebene E1, das mit einem zweiten Bandstück 2 und einem dritten Bandstück 3 in einer hier oberen, zweiten Ebene E2 überlappt. Die Bandstücke 1, 2, 3 sind in der Regel von gleicher Bauart. Die Breiten B1, B2, B3 der Bandstücke 1, 2, 3 sind hier identisch und betragen typischerweise jeweils 7-40 mm.

Zwischen dem zweiten Bandstück 2 und dem dritten Bandstück 3 ist eine Naht 4 ausgebildet, an der die Bandstücke 2, 3 einen Stoß ausbilden. Die Naht 4 ist hier näherungsweise schneckenförmig gewunden; die Verlaufsrichtung der Naht wechselt hier insgesamt zehnmal um 90° oder mehr, wobei sich im Inneren der Schnecke das zweite und dritte Bandstück 2, 3 gegenseitig hintergreifen. Die Weite WT der Naht 4 beträgt typischerweise 10-50 $\mu$m.

Die Bandstücke 1, 2, 3 weisen jeweils ein Substrat 5 auf, hier aus Stahlblech, auf dem eine supraleitende Schicht 6, hier aus YBCO, abgeschieden ist. Die supraleitenden Schichten 6 der Bandstücke 1 einerseits und 2, 3 andererseits sind einander zugewandt. Zwischen den supraleitenden Schichten 6 ist eine Schicht 7 aus einem ersten, normalleitenden Material (etwa eine Sn-Legierung mit Edelmetallausscheidungen) angeordnet. Die Dicke der Schicht 7 ist relativ klein, typischerweise 5-20 μm, um einen Stromübertritt zwischen den supraleitenden Schichten 6 der Bandleiter 1 und 2, 3 nicht zu erschweren. Die supraleitenden Schichten 6 weisen jeweils eine Dicke t von typischerweise 1-3 μm auf. Die Bandstücke 2, 3 weisen meist eine Dicke D2, D3 von ca. 200-400 μm auf, die im Wesentlichen durch das Substrat 5 bestimmt wird.

Die Naht 4 erstreckt sich in Längsrichtung LR (die parallel zur Hauptstromrichtung verläuft) der Supraleiterstruktur 10 über einen Erstreckungsbereich 8 mit einer Länge LBN. Wenn man vom vorderen Ende NE1 entlang der Naht 4 voranschreitet bis zum hinteren Nahtende NE2, so wird eine Pfadlänge PL zurückgelegt.

In der gezeigten Ausführungsform ist LBN etwa doppelt so lang wie B2 oder B3, und weiterhin ist PL ca. achtmal so lang wie B2 oder B3.

Die **Fig. 2** zeigt eine zweite Ausführungsform einer erfindungsgemäßen Supraleiterstruktur 10 in Aufsicht, so dass hier vor allem die Naht 4 am Stoß zwischen zweitem Bandstück 2 und drittem Bandstück 3 illustriert ist.

Die Naht 4 hat hier einen gezackten Verlauf über zwei aufeinander zulaufende Arme, so dass die Pfadlänge gegenüber zwei geraden, aufeinander zulaufenden Armen deutlich verlängert ist. Mit den beiden Armen durchläuft die Naht 4 ihren Erstreckungsbereich 8 in Längsrichtung LR zweimal. Die Naht hat somit einen keilförmigen, beidseits gezackten Verlauf. An jeder Zackenspitze und an jedem Zackengrund bildet die Naht 4 einen Winkel von ca. 90° aus.

Die Zacken können jeweils als (näherungsweise) gleiche Teilstrukturen 9 der Naht aufgefasst werden, die sich an den Armen mehrere Male wiederholen. Diese Teilstrukturen 9 weisen eine maximale Größe (maximaler Durchmesser) MG auf. Bevorzugt ist diese maximale Größe MG kleiner als eine Stromabfall-Distanz SAD der Supraleiterstruktur, die gegeben ist durch

$$ SAD = \sqrt{R_S t / \rho_0} $$

mit $R_S$: spezifischer Kontaktwiderstand einer Shunt-Schicht, hier der Schicht 7 aus dem ersten normalleitenden Material (siehe Fig. 1), und der supraleitenden Schicht 6 (siehe Fig. 1) des ersten Bandstücks 1 (siehe Fig. 1) in Ohm*m²; t: Dicke der Shunt-Schicht, hier Schicht 7, in m; $\rho_0$ spezifischer Widerstand der Shunt-Schicht, hier Schicht 7, in Ohm*m. Mit beispielsweise $R_s=4*10^{-8}$ Ohm*-m², $t=2*10^{-6}$ m und $\rho_0=2*10^{-8}$ Ohm*m ergibt sich ein SAD von 2 mm. Alternativ dazu ergibt sich beispielsweise mit $R_s=10^{-10}$ Ohm*m², $t=10^{-5}$ m und $\rho_0=10^{-9}$ Ohm*m (bei Temperaturen von 4,2 K) ein SAD von 1 mm.

Zudem wird an einem hintergreifenden Teilabschnitt 27 der Zackenflanken erreicht, dass eine lokale Stromrichtung LSR beim Übergang vom zweiten Bandstück 2 zum dritten Bandstück 3 in der Aufsicht eine vektorielle Komponente entgegen der Hauptstromrichtung HSR aufweist. Dadurch wird im ersten Bandstück (in Fig. 2 verdeckt) lokal die effektive Stromstärke durch die lokale Stromrichtung LSR reduziert, was die Stromtragfähigkeit der Supraleiterstruktur 10 verbessern kann.

Die **Fig. 3** zeigt eine dritte Ausführungsform einer erfindungsgemäßen Supraleiterstruktur 10 ähnlich zu der in Fig. 2 gezeigten Ausführungsform. Jedoch sind hier die Ecken der Naht 4 allesamt abgerundet, um Stromspitzen zu vermeiden. Mit anderen Worten, die Teilstrukturen 9 sind hier als Wellen ausgebildet. Der kleinste Krümmungsradius KKR liegt hier etwa bei 1/20*B2 oder 1/20*B3, vergleiche hierzu auch den vergrößerten Kreisausschnitt.

An jeder Welle ändert sich die Verlaufsrichtung der Naht 4 um ca. 270°. Die lokale Stromrichtung LSR bei einem Übergang von Bandstück 2 zu Bandstück 3, die näherungsweise senkrecht zum lokalen Nahtverlauf liegt, ändert sich an jeder Welle entsprechend stark. Dies kann in Überlagerung zu einer lokalen Verminderung der Strombelastung führen, so dass die Stromtragfähigkeit der Supraleiterstruktur 10 gesteigert ist.

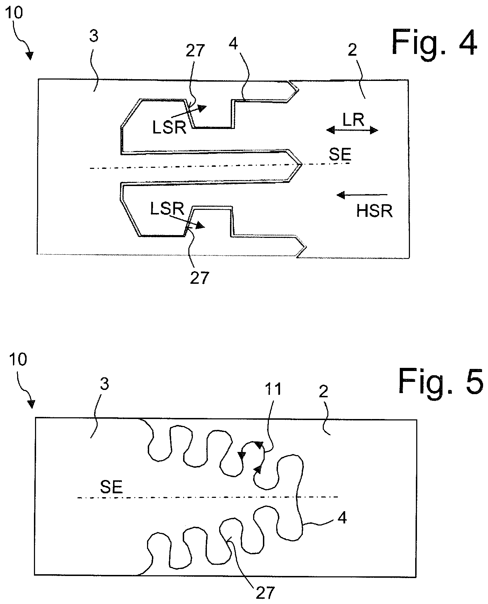

Die **Fig. 4** zeigt eine vierte Ausführungsform einer erfindungsgemäßen Supraleiterstruktur 10, bei der die Naht 4 symmetrisch bezüglich einer Spiegelebene SE ausgebildet ist. Die Spiegelebene SE verläuft mittig in der Supraleiterstruktur 10, parallel zur Längsrichtung LR. Die Naht 4 weist hier zwei hintergreifende Teilabschnitte 27 auf, an denen die lokale Stromflussrichtung LSR der Hauptstromflussrichtung HSR vektoriell teilweise entgegengesetzt ist. Auch in der Ausführungsform von **Fig. 5** ist die Naht 4 der Supraleiterstruktur 10 spiegelsymmetrisch bezüglich einer Spiegelebene SE. Die Naht 4 ist hier dendritenartig ausgebildet, mit einer Vielzahl von schlaufenförmigen Teilabschnitten 11, an denen sich die Verlaufsrichtung jeweils um mehr als 180° ändert, vgl. die an einer Schlaufe eingezeichneten Richtungspfeilchen. Dadurch wird durch die Naht 4 auch eine Vielzahl von hintergreifenden Teilabschnitten 27 ausgebildet.

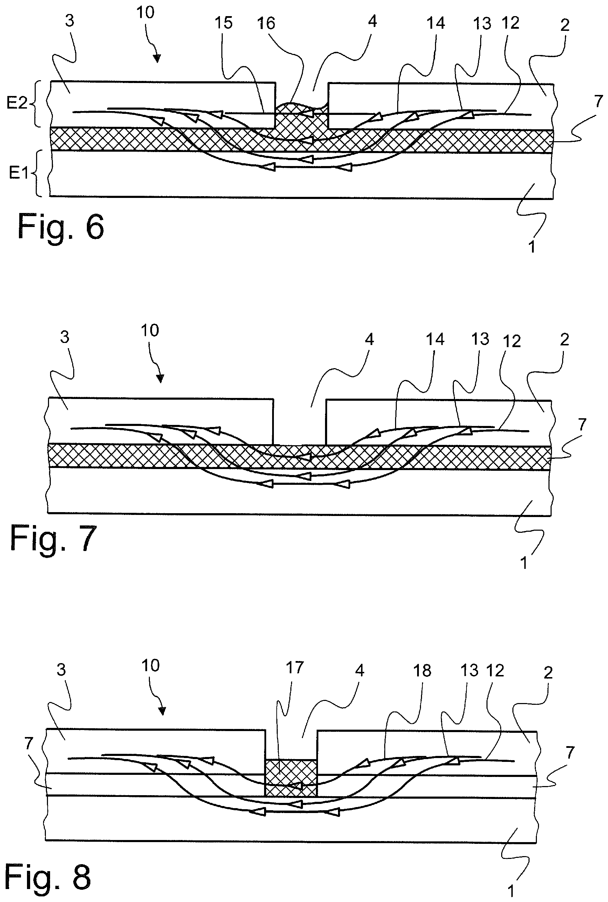

Die **Fig. 6** zeigt in einem Längsschnitt durch eine Supraleiterstruktur 10 beispielhaft den Verlauf von Strömen im Bereich der Naht 4 beim Wechsel vom zweiten Bandstück 2 ins dritte Bandstück 3, zwischen den Ebenen E1 und E2.

Elektrische Ströme, die hier im Bandstück 2 in Ebene E2 auf die Naht 4 zu laufen, durchdringen größtenteils die Schicht 7 aus dem ersten normalleitendem Material und tauchen im ersten Bandstück 1 in der Ebene E1 unter der Naht 4 hindurch. Hinter der Naht 4 gehen sie zurück in die obere Ebene E2 in das dritte Bandstück 3, vgl. Teilströme 12, 13. Ein Teil des Stroms, vgl. Teilstrom 14, dringt lediglich in die Schicht 7 aus dem ersten normalleitenden Material ein, ohne in das erste Bandstück 1 vorzudringen. Ein weiterer Teil des Stromes kann hier auch durch eine (teilweise) Verfüllung 16 der Naht 4 aus einem zweiten normalleitenden Material dringen, vgl. Teilstrom 15. Man beachte, dass für die Verfüllung 16 aus dem zweiten normalleitenden Material auch das gleiche Material wie für die Schicht 7 verwendet werden kann.

In der ersten Ebene E1 fließt - neben den Teilströmen 12, 13 - auch ein Grundstrom, der an der Naht 4 nicht umgelenkt wird (nicht näher eingezeichnet). Dieser Grundstrom in Hauptstromrichtung und die Teilströme 12, 13 dürfen in (vektorieller) Summe den kritischen Strom Ic1 des ersten Bandstücks 1 lokal unter der Naht 4 nicht überschreiten. Deshalb ist es günstig, wenn die Naht 4 schräg zur Hauptstromrichtung verläuft oder gar hintergreifend ist, weil dann die Strombelastung in der ersten Ebene E1 gering gehalten wird.

Die **Fig. 7** illustriert eine Ausführungsform einer Supraleiterstruktur 10 ähnlich zur Ausführungsform von Fig. 6, bei der jedoch die Naht (der Stoß) 4 nicht aufgefüllt ist. In diesem Falle sind nur Teilströme 12, 13 durch das erste Bandstück 1 und ein Teilstrom 14 durch die Schicht 7 möglich.

In der Ausführungsform einer Supraleiterstruktur 10 von **Fig. 8,** die ebenfalls ähnlich ist zur Ausführungsform von Fig. 6, ist die Schicht 7 im Bereich der Naht 4 unterbrochen. Jedoch ist eine Verfüllung 17 aus einem zweiten supraleitenden Material vorgesehen, die sich über die Höhe der Schicht 7 und auch einen Teil der Höhe der Bandstücke 2, 3 erstreckt. In diesem Fall können sich Teilströme 12, 13 durch das erste Bandstück 1 und ein Teilstrom 18 durch die Schicht 7 und die Verfüllung 17 einstellen.

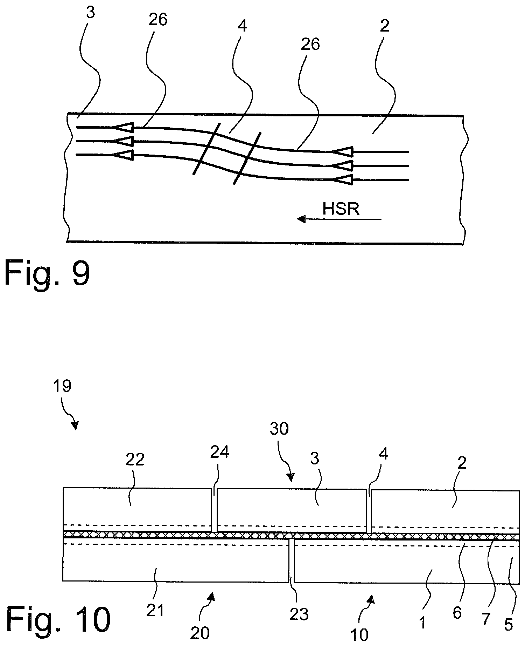

Die **Fig. 9** zeigt in Aufsicht den Stromfluss 26 an einer erfindungsgemäßen Supraleiterstruktur 10 im Bereich einer Naht 4, die schräg zu einer Hauptstromflussrichtung HSR (gleichzeitig Längsrichtung der Supraleiterstruktur 10) verläuft. Der Stromfluss 26 wird durch die Naht 4 gebrochen bzw. abgelenkt, typischerweise sodass der Stromfluss 26 näherungsweise senkrecht zur lokalen Naht 4 erfolgt. Dadurch erhöht der Stromfluss 26 einen Gesamt-Stromfluss im ersten Bandstück (umfassend einen Grund-Stromfluss in Hauptstromflussrichtung und den Stromfluss 26) in Hauptstromflussrichtung HSR effektiv weniger stark im Vergleich zu einem (zusätzlichen) Stromfluss im Hauptstromflussrichtung HSR. Dieser Effekt ist umso größer, je stärker die Ablenkung gegenüber der Hauptstromflussrichtung HSR an der Naht 4 ist; an einem hintergreifenden Nahtabschnitt (nicht eingezeichnet) wird der Gesamt-Stromfluss in Hauptstromflussrichtung sogar reduziert.

Bevorzugt sind die supraleitenden Schichten der Bandstücke, und insbesondere des ersten Bandstücks, bezüglich der jeweiligen kritischen Stromstärke Ic1, Ic2, Ic3 näherungsweise isotrop (d.h. der kritische Strom $Ic^{\parallel}$ parallel zur Hauptstromrichtung HSR liegt jeweils allenfalls geringfügig über dem kritischen Strom $Ic^{\perp}$ senkrecht zu HSR, etwa mit $Ic^{\parallel} / Ic^{\perp} \leq 1,5$ oder bevorzugt $Ic^{\parallel} / Ic^{\perp} \leq 1,1$), so dass die Umlenkung für eine höhere Stromtragfähigkeit auch gut genutzt werden kann.

Die **Fig. 10** zeigt beispielhaft eine erfindungsgemäße Supraleiterbaugruppe 19, umfassend mehrere verkettete Bandstücke 1, 2, 3, 21, 22 mit supraleitenden Schichten 6 bzw. umfassend mehrere erfindungsgemäße Supraleiterstrukturen 10, 20, 30.

Eine Supraleiterstruktur 10 ist ausgebildet mit den Bandstücken 1 (als erstes Bandstück), 2 (als zweites Bandstück) und 3 (als drittes Bandstück), und mit der Naht 4 am Stoß der Bandstücke 2, 3.

Eine weitere Supraleiterstruktur 20 wird gebildet durch die Bandstücke 3 (als erstes Bandstück), 1 (als zweites Bandstück) und 21 (als drittes Bandstück), mit der Naht 23 am Stoß der Bandstücke 1, 21.

Noch eine weitere Supraleiterstruktur 30 wird gebildet durch die Bandstücke 21 (als erstes Bandstück), 3 (als zweites Bandstück) und 22 (als drittes Bandstück), mit Naht 24 am Stoß der Bandstücke 3, 22.

Es versteht sich, dass die Supraleiterbaugruppe 19 um weitere Bandstücke in analoger Weise erweitert werden kann. Mit der Supraleiterbaugruppe 19 können sehr lange Leitungen supraleitend mit hoher Stromtragfähigkeit ausgebildet werden.

## Patentansprüche

**1.** Supraleiterstruktur (10, 20, 30),
umfassend ein erstes Bandstück (1) mit einer ersten Breite B1, ein zweites Bandstück (2) mit einer zweiten Breite B2 und ein drittes Bandstück (3) mit einer dritten Breite B3,
wobei die Bandstücke (1, 2, 3) jeweils ein Substrat (5) und eine auf dem Substrat (5) abgeschiedene, supraleitende Schicht (6) aufweisen, wobei ein Endabschnitt des zweiten Bandstücks (2) und ein Endabschnitt des dritten Bandstücks (3) über eine Schicht (7) aus einem ersten normalleitenden Material mit dem ersten Bandstück (1) verbunden sind, wobei das zweite und dritte Bandstück (2, 3) mit dem ersten Bandstück (1) in Längsrichtung (LR) überlappen,
wobei die supraleitenden Schichten (6) des zweiten und dritten Bandstücks (2, 3) der supraleitenden Schicht (6) des ersten Bandstücks (1) zugewandt sind,
wobei zwischen den Endabschnitten des zweiten und dritten Bandstücks (2, 3) eine Naht (4, 23, 24) ausgebildet ist, wobei die Naht (4, 23, 24) eine Pfadlänge PL aufweist mit PL > 2*B2 und PL > 2*B3, insbesondere wobei sich die Schicht (7) aus dem ersten normalleitenden Material auch unter der Naht (4, 23, 24) erstreckt,
**dadurch gekennzeichnet,**
**dass** sich die Naht (4, 23, 24) in Längsrichtung (LR) über einen Erstreckungsbereich (8) der Supraleiterstruktur (10, 20, 30) erstreckt, der eine Länge LBN aufweist, mit 0,5*PL $\geq$ LBN, bevorzugt 0,25*PL $\geq$ LBN.

**2.** Supraleiterstruktur (10, 20, 30) nach Anspruch 1, **dadurch gekennzeichnet, dass** die Naht (4, 23, 24) den Erstreckungsbereich (8) oder einen Teilbereich des Erstreckungsbereichs (8), der ein Teilstück des Erstreckungsbereichs (8) in Längsrichtung (LR) herausgreift, bezüglich der Längsrichtung (LR) mehrfach durchläuft.

**3.** Supraleiterstruktur (10, 20, 30) nach einem der vorhergehenden Ansprüche, **dadurch gekennzeichnet, dass** die Naht (4, 23, 24) wenigstens zur Hälfte einen nichtlinearen und/oder polygonalen Verlauf hat.

**4.** Supraleiterstruktur (10, 20, 30) nach einem der vorhergehenden Ansprüche, **dadurch gekennzeichnet, dass** die Naht (4, 23, 24) wenigstens einen Teilabschnitt (11) aufweist, in welchem sich eine Verlaufsrichtung der Naht (4, 23, 24) um 180° oder mehr, insbesondere um 270° oder mehr, ändert.

**5.** Supraleiterstruktur (10, 20, 30) nach einem der vorhergehenden Ansprüche, **dadurch gekennzeichnet, dass** die Naht (4, 23, 24) in wenigstens einem Teilabschnitt gezackt oder gewellt verläuft, insbesondere wobei die Naht (4, 23, 24) in dem Teilabschnitt in Form eines Keils mit einem beidseitig gezackten oder gewellten Rand verläuft.

**6.** Supraleiterstruktur (10, 20, 30) nach einem der vorhergehenden Ansprüche, **dadurch gekennzeichnet, dass** die Naht (4, 23, 24) wenigstens einen Teilabschnitt aufweist, in welchem die Naht (4, 23, 24) schneckenförmig verläuft.

**7.** Supraleiterstruktur (10, 20, 30) nach einem der vorhergehenden Ansprüche, **dadurch gekennzeichnet,**
**dass** die Naht (4, 23, 24) mehrere im Wesentlichen gleiche Teilstrukturen (9), insbesondere Zacken oder Wellen, ausbildet, die eine maximale Größe MG aufweisen,
und **dass** die Supraleiterstruktur (10, 20, 30) eine Stromabfall-Distanz SAD aufweist, mit MG < SAD, wobei SAD wie folgt bestimmt ist:

$$SAD = \sqrt{R_S t / \rho_0}$$

mit $R_S$: spezifischer Kontaktwiderstand einer Shunt-Schicht und der supraleitenden Schicht (6) des ersten Bandstücks (1) in Ohm*m$^2$; t: Dicke oder effektive Dicke der Shunt-Schicht in m; $\rho_0$ spezifischer Widerstand oder effektiver spezifischer Widerstand der Shunt-Schicht in Ohm*m; wobei die Shunt-Schicht zumindest die Schicht (7) aus dem ersten normalleitenden Material umfasst..

**8.** Supraleiterstruktur (10, 20, 30) nach einem der vorhergehenden Ansprüche, **dadurch gekennzeichnet, dass** die Naht (4, 23, 24) mit abgerundeten Ecken ausgebildet ist,
so dass für einen kleinsten Krümmungsradius KKR der Naht (4, 23, 24) gilt
$KKR \geq 0{,}01*B2$ und $KKR \geq 0{,}01*B3$,
bevorzugt wobei $0{,}2*B2 \geq KKR \geq 0{,}01*B2$ und $0{,}2*B3 \geq KKR \geq 0{,}01*B3$.

**9.** Supraleiterstruktur (10, 20, 30) nach einem der vorhergehenden Ansprüche, **dadurch gekennzeichnet, dass**
$PL \geq 5*B2$ und $PL \geq 5*B3$,
bevorzugt $PL \geq 12*B2$ und $PL \geq 12*B3$,
besonders bevorzugt $PL \geq 25*B2$ und $PL \geq 25*B3$.

**10.** Supraleiterstruktur (10, 20, 30) nach einem der vorhergehenden Ansprüche, **dadurch gekennzeichnet, dass** das zweite Bandstück (2) eine Dicke D2 und das dritte Bandstück eine Dicke D3 aufweist, und die Naht (4, 23, 24) eine Weite WT aufweist, mit $0{,}01*D2 \leq WT \leq 3*D2$ und $0{,}01*D3 \leq WT \leq 3*D3$, bevorzugt $0{,}02*D2 \leq WT \leq 2*D2$ und $0{,}02*D3 \leq WT \leq 2*D3$.

**11.** Supraleiterstruktur (10, 20, 30) nach einem der vorhergehenden Ansprüche, **dadurch gekennzeichnet, dass** $2*B1 \leq LBN \leq 100*B1$.

**12.** Supraleiterstruktur (10, 20, 30) nach einem der vorhergehenden Ansprüche, **dadurch gekennzeichnet, dass** die Naht bezüglich einer Symmetrieebene (SE), die entlang der Längsrichtung (LR) mittig durch die Supraleiterstruktur (10, 20, 30) und senkrecht zu den Substraten (5) verläuft, symmetrisch ausgebildet ist.

**13.** Supraleiterstruktur (10, 20, 30) nach einem der vorhergehenden Ansprüche, **dadurch gekennzeichnet, dass** die Naht (4, 23, 24) zumindest teilweise mit einem zweiten normalleitenden Material ausgefüllt ist.

**14.** Supraleiterstruktur (10, 20, 30) nach Anspruch 13, **dadurch gekennzeichnet, dass** das zweite normalleitende Material ein niederschmelzendes Lot mit einer Schmelztemperatur von 80°-350°C ist, insbesondere wobei das zweite normalleitende Material eine Legierung enthaltend Bi, Sn, Pb, Cd und/oder Sn mit Ausscheidungen von Ag, Au und/oder Cu ist.

**15.** Supraleiterstruktur (10, 20, 30) nach einem der vorhergehenden Ansprüche, **dadurch gekennzeichnet, dass** die Naht (4, 23, 24) wenigstens einen, bevorzugt wenigstens zwei, Teilabschnitte (27) aufweist, an denen sich das zweite Bandstück (2) und das dritte Bandstück (3) gegenseitig hintergreifen.

**16.** Supraleiterstruktur (10, 20, 30) nach einem der vorhergehenden Ansprüche, **dadurch gekennzeichnet, dass** das Material der supraleitenden Schichten (6) der Bandstücke (1, 2, 3) eine Anisotropie der jeweiligen kritischen Ströme (Ic$^{\parallel}$, Ic$^{\perp}$) in der jeweiligen Schicht (6) entlang der Längsrichtung (LR) zu senkrecht zur Längsrichtung (LR) von 1,5 oder weniger, bevorzugt von 1,1 oder weniger, aufweist.

**17.** Supraleiterbaugruppe (19), umfassend mehrere Supraleiterstrukturen (10, 20, 30) nach einem der vorhergehenden Ansprüche, insbesondere wobei jeweils zwei Supraleiterstrukturen (10, 20, 30) elektrisch seriell über ihr jeweiliges zweites oder drittes Bandstück (2, 3) miteinander verbunden sind.

**18.** Verwendung einer Supraleiterstruktur (10, 20, 30) nach einem der Ansprüche 1 bis 16 und/oder einer Supraleiterbaugruppe (19) nach Anspruch 17, wobei das erste Bandstück (1) eine kritische Stromstärke Ic1, das zweite Bandstück (2) eine kritische Stromstärke Ic2, und das dritte Bandstück (3) eine kritische Stromstärke Ic3 aufweist, und wobei die Supraleiterstruktur (10, 20, 30) mit einem Arbeitsstrom IA beaufschlagt wird, wobei gilt Ic1 < IA < Ic1+Ic2 und Ic1 < IA < Ic1+Ic3, bevorzugt 1,1*Ic1 $\leq$ IA $\leq$ 0,9*(Ic1+Ic2) und 1,1*Ic1 $\leq$ IA $\leq$ 0,9*(Ic1+ Ic3).

**19.** Verwendung nach Anspruch 18, **dadurch gekennzeichnet, dass** die Supraleiterstruktur (10, 20, 30) und/oder Supraleiterbaugruppe (19) verbaut ist in

- einer Magnetspule,
- einem Elektromotor oder einem Generator,
- einem Transformator, oder
- einer Stromleitung.

**Claims**

**1.** A superconductor structure (10, 20, 30), comprising a first strip piece (1) with a first width B1, a second strip piece (2) with a second width B2, and a third strip piece (3) with a third width B3, wherein the strip pieces (1, 2, 3) each comprise a substrate (5) and a superconducting layer (6) deposited on the substrate (5), wherein one end section of the second strip piece (2) and one end section of the third strip piece (3) are connected via a layer (7) made from a first normally conducting material to the first strip piece (1), wherein the second and third strip piece (2, 3) overlap with the first strip piece (1) in the longitudinal direction (LR), wherein the superconducting layers (6) of the second and third strip piece (2, 3) of the superconducting layer (6) of the first strip piece (1) face one another, wherein between the end sections of the second and third strip piece (2, 3) a seam (4, 23, 24) is formed, wherein the seam (4, 23, 24) has a path length PL with PL > 2*B2 and PL > 2*B3, in particular wherein the layer (7) made from the first normally conducting material also extends under the seam (4, 23, 24), **characterized in that** the seam (4, 23, 24) extends in a longitudinal direction (LR) over an extension region (8) of the superconductor structure (10, 20, 30) having a length LBN with 0.5*PL $\geq$ LBN, preferably 0.25*PL $\geq$ LBN.

**2.** The superconductor structure (10, 20, 30) according to claim 1, **characterized in that** the seam (4, 23, 24) passes through the extension region (8) or a partial region of the extension region (8), which selects a section of the extension region (8) in the longitudinal direction (LR), multiple times with respect to the longitudinal direction (LR).

**3.** The superconductor structure (10, 20, 30) according to one of the preceding claims, **characterized in that** at least half of the seam (4, 23, 24) has a nonlinear and/or polygonal course.

**4.** The superconductor structure (10, 20, 30) according to one of the preceding claims, **characterized in that** the seam (4, 23, 24) has at least a partial section (11), in which a course direction of the seam (4, 23, 24) changes by 180° or more, in particular by 270° or more.

**5.** The superconductor structure (10, 20, 30) according to one of the preceding claims, **characterized in that** the seam (4, 23, 24) in at least one partial section is jagged or wavy, in particular wherein the seam (4, 23, 24) in the partial section is in the form of a wedge with jagged or wavy edges on both sides.

**6.** The superconductor structure (10, 20, 30) according to one of the preceding claims, **characterized in that** the seam (4, 23, 34) has at least a partial section in which the seam (4, 23, 24) is helical.

**7.** The superconductor structure (10, 20, 30) according to one of the preceding claims, **characterized in that** the seam (4, 23, 24) forms a number of substantially identical partial structures (9), in particular jags or waves, which have a maximal size MG, and that the superconductor structure (10, 20, 30) has a current drop distance SAD, with MG < SAD wherein SAD is determined as follows:

$$SAD = \sqrt{R_S t / \rho_0}$$

with Rs being the specific contact resistance of a shunt layer and the superconducting layer (6) of the first strip piece (1) in Ohm*m$^2$; t is the thickness or effective thickness of the shunt layer in m; po is the specific resistance or effective specific resistance of the shunt layer in Ohm*m; wherein the shunt layer comprises at least the layer (7) made from the first normally conducting material.

8. The superconductor structure (10, 20, 30) according to one of the preceding claims, **characterized in that** that the seam (4, 23, 24) is formed with rounded corners,
so that for a minimal radius of curvature KKR of the seam (4, 23, 24),
KKR $\geq$ 0.01*B2 and KKR $\geq$ 0.01*B3,
preferably wherein 0.2*B2 $\geq$ KKR $\geq$ 0.01*B2 and 0.2*B3 $\geq$ KKR $\geq$ 0.01*B3.

9. The superconductor structure (10, 20, 30) according to one of the preceding claims, **characterized in that** PL $\geq$ 5*B2 and PL $\geq$ 5*B3,
preferably PL $\geq$ 12*B2 and PL $\geq$ 12*B3,
especially preferably PL $\geq$ 25*B2 and PL $\geq$ 25*B3.

10. The superconductor structure (10, 20, 30) according to one of the preceding claims, **characterized in that** the second strip piece (2) has a thickness D2 and the third strip piece has a thickness D3, and the seam (4, 23, 24) has a width WT,
with 0.01*D2 $\leq$ WT $\leq$ 3*D2 and 0.01*D3 $\leq$ WT $\leq$ 3*D3,
preferably 0.02*D2 $\leq$ WT $\leq$ 2*D2 and 0.02*D3 $\leq$ WT $\leq$ 2*D3.

11. The superconductor structure (10, 20, 30) according to one of the preceding claims, **characterized in that** 2*B1 $\leq$ LBN $\leq$ 100*B1.

12. The superconductor structure (10, 20, 30) according to one of the preceding claims, **characterized in that** the seam is symmetrically formed with respect to a plane of symmetry (SE), which runs along the longitudinal direction (LR) through the middle of the superconductor structure (10, 20, 30) and perpendicular to the substrates (5).

13. The superconductor structure (10, 20, 30) according to one of the preceding claims, **characterized in that** the seam (4, 23, 24) is filled at least partially with a second normally conducting material.

14. The superconductor structure (10, 20, 30) according to claim 13, **characterized in that** the second normally conducting material is a low-melting solder with a melting temperature of 80°-350° C, in particular wherein the second normally conducting material is an alloy containing Bi, Sn, Pb, Cd, and/or Sn with precipitates of Ag, Au, and/or Cu.

15. The superconductor structure (10, 20, 30) according to one of the preceding claims, **characterized in that** the seam (4, 23, 24) has at least one, preferably at least two partial sections (27), at which the second strip piece (2) and the third strip piece (3) engage behind each other.

16. The superconductor structure (10, 20, 30) according to one of the preceding claims, **characterized in that** the material of the superconducting layers (6) of the strip pieces (1, 2, 3) has an anisotropy of the respective critical currents (Ic$^{\parallel}$, Ic$^{\perp}$) in the respective layer (6) along the longitudinal direction (LR) as compared to perpendicular to the longitudinal direction (LR) of 1.5 or less, preferably 1.1 or less.

17. A superconductor structural group (19), comprising a number of superconductor structures (10, 20, 30) according to one of the preceding claims,
in particular wherein two superconductor structures (10, 20, 30) are electrically series connected to one another via their respective second or third strip piece (2, 3) in each case.

18. Use of a superconductor structure (10, 20, 30) according to one of claims 1 to 16 and/or of a superconductor structural group (19) according to claim 17, wherein the first strip piece (1) has a critical current strength Ic1, the second strip piece (2) has a critical current strength Ic2, and the third strip piece (3) has a critical current strength Ic3,
and wherein the superconductor structure (10, 20, 30) is acted on with a load current IA, wherein
Ic1 < IA < Ic1+Ic2 and Ic1 < IA < Ic1+Ic3,
preferably 1.1*Ic1 $\leq$ IA $\leq$ 0.9*(Ic1+Ic2) and 1.1*Ic1 $\leq$ IA $\leq$ 0.9*(Ic1+ Ic3).

19. Use according to claim 18, **characterized in that** the superconductor structure (10, 20, 30) and/or superconductor structural group (19) is built in

- a magnetic coil,
- an electric motor or a generator,
- a transformer, or
- a power line.

**Revendications**

1. Structure supraconductrice (10, 20, 30), comprenant un premier morceau de ruban (1) ayant une première largeur B1, un deuxième morceau de ruban (2) ayant une deuxième largeur B2 et un troisième morceau de ruban (3) ayant une troisième largeur B3,
dans laquelle les morceaux de ruban (1, 2, 3) comportent chacun un substrat (5) et une couche supraconductrice (6) déposée sur le substrat (5),
dans laquelle une partie d'extrémité du deuxième morceau de ruban (2) et une partie d'extrémité du troisième morceau de ruban (3) sont reliées au premier morceau de ruban (1) par une couche (7) constituée d'un premier matériau ayant une conductivité normale,

dans laquelle les deuxième et troisième morceaux de ruban (2, 3) chevauchent le premier morceau de ruban (1) dans la direction longitudinale (LR),

dans laquelle les couches supraconductrices (6) des deuxième et troisième morceaux de ruban (2, 3) de la couche supraconductrice (6) du premier morceau de ruban (1) sont en face l'un de l'autre,

dans laquelle une soudure (4, 23, 24) est réalisée entre les parties d'extrémité des deuxième et troisième morceaux de ruban (2, 3), dans laquelle la soudure (4, 23, 24) présente une longueur de trajet PL, avec PL > 2*B2 et PL > 2*B3,

en particulier dans laquelle la couche (7) constituée du premier matériau ayant une conductivité normale s'étend également sous la soudure (4, 23, 24), **caractérisée en ce que** la soudure (4, 23, 24) s'étend dans la direction longitudinale (LR) sur une région d'extension (8) de la structure supraconductrice (10, 20, 30) ayant une longueur LBN, avec 0,5*PL ≥ LBN, de préférence 0,25*PL ≥ LBN.

2. Structure supraconductrice (10, 20, 30) selon la revendication 1, **caractérisée en ce que** la soudure (4, 23, 24) traverse plusieurs fois, par rapport à la direction longitudinale (LR), la région d'extension (8) ou une région partielle de la région d'extension (8) qui atteint une partie de la région d'extension (8) dans la direction longitudinale (LR).

3. Structure supraconductrice (10, 20, 30) selon l'une des revendications précédentes, **caractérisée en ce qu'**au moins la moitié de la soudure (4, 23, 24) présente un parcours non linéaire et/ou polygonal.

4. Structure supraconductrice (10, 20, 30) selon l'une des revendications précédentes, **caractérisée en ce que** la soudure (4, 23, 24) présente au moins une section partielle (11) dans laquelle une direction d'extension de la soudure (4, 23, 24) change de 180° ou plus, en particulier de 270° ou plus.

5. Structure supraconductrice (10, 20, 30) selon l'une des revendications précédentes, **caractérisée en ce que** la soudure (4, 23, 24) est dentelée ou ondulée dans au moins une section partielle, en particulier dans laquelle la soudure (4, 23, 24) s'étend dans la section partielle sous la forme d'un coin ayant sur ses deux côtés un bord dentelé ou ondulé.

6. Structure supraconductrice (10, 20, 30) selon l'une des revendications précédentes, **caractérisée en ce que** la soudure (4, 23, 24) présente au moins une section partielle dans laquelle la soudure (4, 23, 24) s'étend de manière hélicoïdale.

7. Structure supraconductrice (10, 20, 30) selon l'une des revendications précédentes, **caractérisée en ce que** la soudure (4, 23, 24) forme une pluralité de sous-structures (9) sensiblement identiques, en particulier des dents ou des ondulations, qui ont une taille maximale MG, et **en ce que** la structure supraconductrice (10, 20, 30) présente une distance de décroissance du courant SAD, avec MG < SAD, où SAD est déterminé comme suit :

$$SAD = \sqrt{R_s t / \rho_0}$$

avec Rs : résistance de contact spécifique d'une couche de shunt et de la couche supraconductrice (6) du premier morceau de ruban (1) en Ohm*m$^2$ ; t : épaisseur ou épaisseur effective de la couche de shunt en m ; $\rho_0$ : résistance spécifique ou résistance spécifique effective de la couche de shunt en Ohm*m ; dans laquelle la couche de shunt comprend au moins la couche (7) constituée du premier matériau ayant une conductivité normale.

8. Structure supraconductrice (10, 20, 30) selon l'une des revendications précédentes, **caractérisée en ce que** la soudure (4, 23, 24) est réalisée avec des angles arrondis de manière à ce que, pour un rayon de courbure le plus faible KKR de la soudure (4, 23, 24), on ait

KKR ≥ 0,01*B2 et KKR ≥ 0,01*B3,

et de préférence 0,2*B2 ≥ KKR ≥ 0,01*B2 et 0,2*B3 ≥ KKR ≥ 0,01*B3.

9. Structure supraconductrice (10, 20, 30) selon l'une des revendications précédentes, **caractérisée en ce que**

PL ≥ 5*B2 et PL ≥ 5*B3,

de préférence PL ≥ 12*B2 et PL ≥ 12*B3,

et de manière particulièrement préférable PL ≥ 25*B2 et PL ≥ 25*B3.

10. Structure supraconductrice (10, 20, 30) selon l'une des revendications précédentes, **caractérisée en ce que** le deuxième morceau de ruban (2) présente une épaisseur D2 et le troisième morceau de ruban présente une épaisseur D3, et la soudure (4, 23, 24) présente une largeur WT,

avec 0,01*D2 ≤ WT ≤ 3*D2 et 0,01*D3 ≤ WT ≤ 3*D3,

et de préférence 0,02*D2 ≤ WT ≤ 2*D2 et 0,02*D3 ≤ WT ≤ 2*D3.

11. Structure supraconductrice (10, 20, 30) selon l'une des revendications précédentes, **caractérisée en ce que** 2*B1 ≤ LBN ≤ 100*B1.

**12.** Structure supraconductrice (10, 20, 30) selon l'une des revendications précédentes, **caractérisée en ce que** la soudure est symétrique par rapport à un plan de symétrie (SE) qui s'étend centralement le long de la direction longitudinale (LR) à travers la structure supraconductrice (10, 20, 30) et perpendiculairement aux substrats (5).

**13.** Structure supraconductrice (10, 20, 30) selon l'une des revendications précédentes, **caractérisée en ce que** la soudure (4, 23, 24) est au moins partiellement remplie d'un deuxième matériau ayant une conductivité normale.

**14.** Structure supraconductrice (10, 20, 30) selon la revendication 13, **caractérisée en ce que** le deuxième matériau ayant une conductivité normale est une brasure à bas point de fusion ayant une température de fusion de 80°-350°C, en particulier dans laquelle le deuxième matériau ayant une conductivité normale est un alliage contenant du Bi, du Sn, du Pb, du Cd et/ou du Sn avec des précipités d'Ag, d'Au et/ou de Cu.

**15.** Structure supraconductrice (10, 20, 30) selon l'une des revendications précédentes, **caractérisée en ce que** la soudure (4, 23, 24) présente au moins une, et de préférence au moins deux, sections partielles (27) sur lesquelles le deuxième morceau de ruban (2) et le troisième morceau de ruban (3) s'engagent l'un dans l'autre.

**16.** Structure supraconductrice (10, 20, 30) selon l'une des revendications précédentes, **caractérisée en ce que** le matériau des couches supraconductrices (6) des morceaux de ruban (1, 2, 3) présente une anisotropie des courants critiques respectifs ($Ic^{\parallel}$, $Ic^{\perp}$) dans la couche respective (6) le long de la direction longitudinale (LR) perpendiculairement à la direction longitudinale (LR) de 1,5 ou moins, et de préférence de 1,1 ou moins.

**17.** Ensemble supraconducteur (19) comprenant une pluralité de structures supraconductrices (10, 20, 30) selon l'une des revendications précédentes, en particulier dans lequel deux structures supraconductrices (10, 20, 30) sont respectivement reliées électriquement en série l'une à l'autre par l'intermédiaire de leur deuxième ou troisième morceau de ruban respectif (2, 3).

**18.** Utilisation d'une structure supraconductrice (10, 20, 30) selon l'une des revendications 1 à 16 et/ou d'un ensemble supraconducteur (19) selon la revendication 17,
dans laquelle le premier morceau de ruban (1) présente un courant critique Ic1, le deuxième morceau de ruban (2) présente un courant critique Ic2 et le troisième morceau de ruban (3) présente un courant critique Ic3, et dans laquelle la structure supraconductrice (10, 20, 30) est soumise à un courant de fonctionnement IA, dans laquelle on a
Ic1 < IA < Ic1+Ic2 et Ic1 < IA < Ic1+Ic3,
et de préférence 1,1*Ic1 $\leq$ IA $\leq$ 0,9*(Ic1+Ic2) et 1,1*Ic1 $\leq$ IA $\leq$ 0,9*(Ic1 + Ic3).

**19.** Utilisation selon la revendication 18, **caractérisée en ce que** la structure supraconductrice (10, 20, 30) et/ou l'ensemble supraconducteur (19) est monté dans

- un solénoïde,
- un moteur électrique ou un générateur,
- un transformateur, ou
- une ligne électrique.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

**In der Beschreibung aufgeführte Patentdokumente**

- DE 102012218251 A1
- US 8195260 B2
- JP 2014154320 A